# EUROPEAN PATENT APPLICATION

(11) **EP 3 352 363 A1**
(43) Date of publication of application: **25.07.2018**
(21) Application number: 16846193.7
(22) Date of filing: 18.08.2016
(51) Int. Cl.: H02M 7/48, H02M 7/483

(54) **POWER CONVERTER CONTROL DEVICE**

(30) Priority: 18.09.2015 JP 2015185472
(71) Applicant: Kabushiki Kaisha Toshiba, Minato-ku Tokyo 105-8001 (JP); Toshiba Energy Systems & Solutions Corporation, Saiwai-ku Kawasaki-shi Kanagawa 2120013 (JP)
(72) Inventor: KOYAMA, Yushi, Tokyo 105-8001 (JP); HASEGAWA, Ryuta, Tokyo 105-8001 (JP); TAMADA, Shunsuke, Tokyo 105-8001 (JP); ARAI, Takuro, Tokyo 105-8001 (JP); SEKIGUCHI, Kei, Tokyo 105-8001 (JP)
(74) Representative: AWA Sweden AB
(86) International application number: PCT/JP2016/074138
(87) International publication number: WO 2017/047322

(57) **Abstract**

According to one embodiment, there is provided a control apparatus including a first control calculation device (1) that calculates an output command value of one or more main circuits (5) including a semiconductor switching element; and one or more second control calculation devices (8) that convert the output command value to a gate signal of the semiconductor switching element. The output command value is transmitted from the first control calculation device (1) to the second control calculation devices (8) by wireless communication. The second control calculation devices (8) transmit the gate signal converted from the transmitted output command value to a gate substrate (4) that drives the semiconductor switching element based on the gate signal.

## Description

### Technical Field

Embodiments described herein relate generally to a control apparatus for a power converter.

### Background Art

As semiconductor technologies have developed, techniques of a switching element for use in a power converter (inverter) have advanced. As one of the results of the advancement, a multilevel construction of a converter is known. According to conventional art, to realize a high-voltage power converter in the case of interconnecting the power converter to a high-voltage power system or driving a high-voltage motor, etc., converter outputs of two or three levels are generally boosted by a transformer.

A multilevel circuit capable of outputting, for example, five levels of voltage, such as an A-NPC (Active-Neutral Point Clamped) circuit or an MMC (Modular Multilevel Converter) circuit, allows an output voltage of a power converter to be multilevel, thereby approximating the waveform of the output voltage to a sine wave. The MMC circuit can increase the levels of voltage to a discretionary number by serially connecting a plurality of unit converters that output small voltages. Harmonics can be reduced by approximating the waveform of the output voltage to a sign wave, as described above. A harmonic filter formed of a reactor or a capacitor and provided in a power converter is disadvantageous in terms of volume, dimensions, and cost. However, the number of harmonic filters can be reduced by reducing the harmonic waves as described above. Furthermore, in the converter of two or three voltage levels, a switching loss or a filter loss at one time is relatively large. In contrast, in a multilevel circuit, a switching loss or a filter loss at one time can be small, because the multilevel circuit switches voltages in small ranges.

The multilevel circuit includes a number of semiconductor switching elements. Therefore, the multilevel circuit requires a number of gate signals transmitted at the same timing (which may be hereinafter referred to as the number of gate signals) to drive the semiconductor switching elements. In particular, unit power converters provided in an MMC circuit each include a chopper including two switching elements and four full bridges. Therefore, as the number of unit converters serially connected is increased, the number of switching elements mentioned above is increased, which also increases the number of gate signals in the overall apparatus. As the number of gate signals is increased, the number of signal lines that must be provided between a control calculation device for the power converter and a gate substrate is increased, which increases costs and dimensions of the overall apparatus.

Furthermore, as a transmission technique applied in a case where high-voltage equipment is used, or where the distance between a control calculation device and a gate substrate is long, there is a known technique of converting a gate signal from the control calculation device to an optical signal and transmitting the optical signal to the gate substrate via an optical fiber. However, since equipment to convert a gate signal to an optical signal and transmit the optical signal is expensive, costs of the overall apparatus are considerably increased if the number of gate signals is large.

To solve the problems described above, for example, there is a known method of reducing the number of gate signals, for example, by serially converting a plurality of parallel gate signals from the control calculation device, and thereafter transmitting the gate signals to the gate substrate.

### [Prior Art Reference]

### [Patent Literature]

[Patent Literature 1] Jpn. Pat. Appln. KOKAI Publication No. 9-201064

### Summary of the Invention

### [Technical Problem]

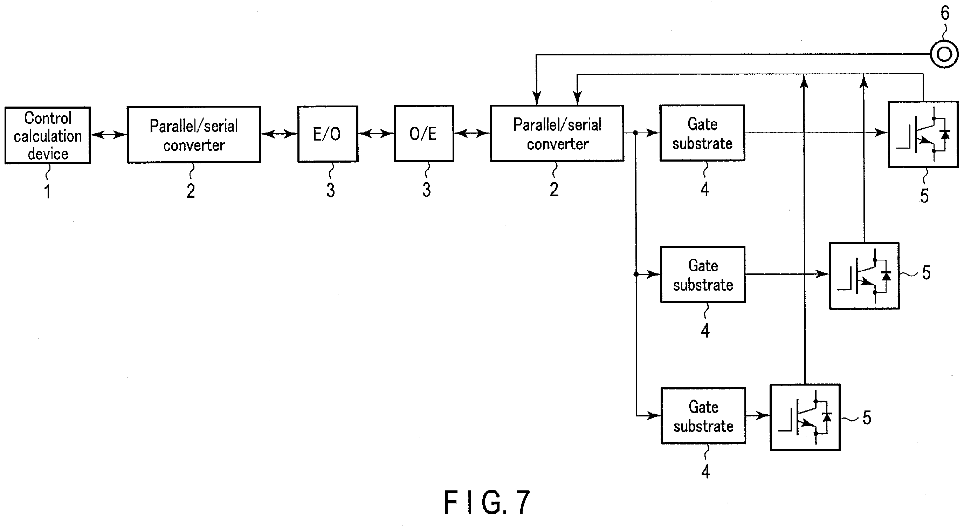

FIG. 7 is a diagram showing an example of transmission of a gate signal by a conventional control apparatus for a power converter. In the example shown in FIG. 7, a plurality of parallel gate signals generated by a control calculation device 1 is converted to a serial signal by a parallel/serial converter 2 on a transmission side. The serial signal is converted into an optical signal by a electrical/optical converter 3 on the transmission side and transmitted to a reception side through an optical fiber. The transmitted optical signal is converted into an electric signal by a optical/electrical converter 3 on the reception side. The electric signal is converted into parallel gate signals by a parallel/serial converter 2 on the reception side. The parallel gate signals are transferred to gate substrates 4 respectively, thereby driving switching elements of main circuits (power converter main circuits) 5 corresponding to the respective gate substrates 4.

The parallel/serial converter 2 on the reception side also converts a voltage detection value of a DC capacitor of each main circuit 5 and a current detection value detected by a current sensor 6 to a serial signal. The serial signal, as well as the gate signal, is converted into an optical signal and transmitted to the control calculation device 1 as a feedback signal.

According to the method described above, the gate signal and the feedback signal are converted into serial signals, and transmitted between the control calculation device 1 and the main circuit 5; therefore, the number of signals can be reduced. However, the number of parallel gate signals that can be converted to one serial signal by parallel/serial conversion is, practically speaking, around several tens of signals. Therefore, in an apparatus using the MMC circuit, where the number of parallel gate signals is of the order of several hundreds, the number of gate signals cannot be sufficiently reduced. Furthermore, the optical fiber is still expensive.

An object of the present invention is to provide a control apparatus for a power converter that can ensure the reliability of gate signals, while reducing costs and dimensions.

### Brief Description of Drawings

FIG. 1 is a diagram showing a configuration example of a control apparatus for a power converter according to a first embodiment.
FIG. 2 is a diagram showing a configuration example of a control apparatus for a power converter according to a second embodiment.
FIG. 3 is a diagram showing a configuration example of a control apparatus for a power converter according to a third embodiment.
FIG. 4 is a diagram showing a configuration example of a control apparatus for a power converter according to a fourth embodiment.
FIG. 5 is a diagram for explaining an example of inertia control performed during a communication error time according to an eighth embodiment.
FIG. 6 is a diagram for explaining an example of inertia control based on an average value in communication error time according to a ninth embodiment.
FIG. 7 is a diagram showing an example of wired serial gate transmission in a conventional control apparatus for a power converter.

### Description of Embodiments

In general, according to one embodiment, there is provided a control apparatus for a power converter including a first control calculation device that calculates an output command value of one or more main circuits including a semiconductor switching element; and one or more second control calculation devices that convert the output command value to a gate signal of the semiconductor switching element. The output command value is transmitted from the first control calculation device to the second control calculation devices by wireless communication. The second control calculation devices transmit the gate signal converted from the transmitted output command value to a gate substrate that drives the semiconductor switching element based on the gate signal.

Hereinafter, the embodiments will be described with reference to the drawings.

### (First Embodiment)

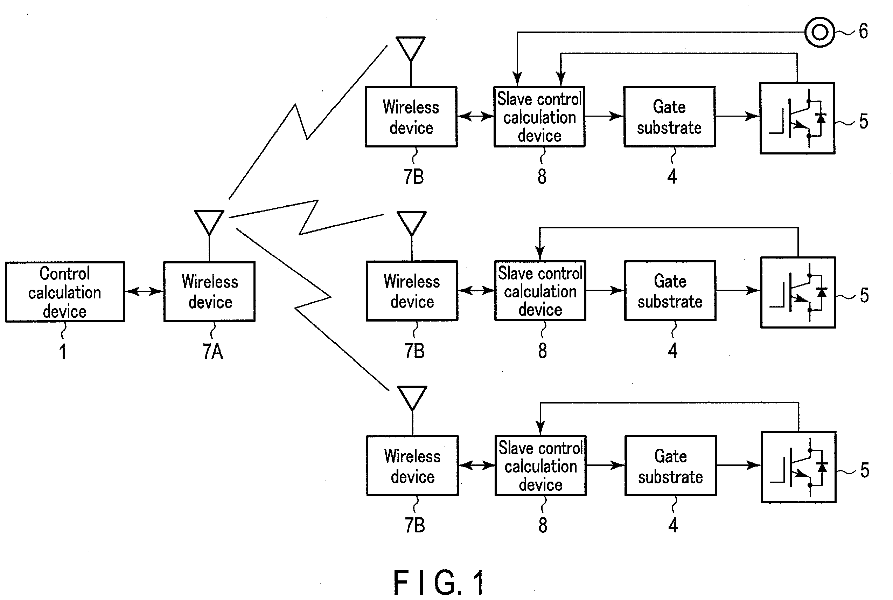

FIG. 1 is a diagram showing a configuration example of a control apparatus for a power converter according to a first embodiment.

In this embodiment, a plurality of power converter main circuits 5 including semiconductor switching elements are provided as power converters. A unit power converter, such as a chopper or a full-bridge configuration, is applicable as each of the power converter main circuits 5. The unit power converter includes a plurality of semiconductor switching elements and a DC voltage source, such as a capacitor. The control apparatus for the power converter includes a control calculation device 1 (a first control calculation device) that calculates an output voltage command value to drive the power converter main circuits 5; and a slave control calculation device 8 (a second control calculation device) that converts the output voltage command value to a gate signal. A gate substrate 4 is provided to correspond to each of the power converter main circuits 5. Based on the gate signal, the gate substrate 4 generates a signal to drive the semiconductor switching element of the power converter main circuit 5, and drives the semiconductor switching element based on the signal. As shown in FIG. 1, gate substrates 4 are provided for the respective power converter main circuits 5 in a one-to-one correspondence.

Furthermore, as communication devices between the control calculation device 1 and the slave control calculation device 8, a wireless device (wireless communication device) 7A and a wireless device 7B, that convert from an electric signal to a wireless signal and from a wireless signal to an electrical signal, are provided. The wireless device 7A is connected to the control calculation device 1. The wireless device 7B is connected to the slave control calculation device 8.

A current sensor 6 that detects a current value of a current flowing through a predetermined part of a specific power converter main circuit 5 is also provided.

The example shown in FIG. 1 includes one control calculation device 1, one wireless device 7A, and a plurality of groups each including the wireless device 7B, the slave control calculation device 8, the gate substrate 4, and the power converter main circuit 5. FIG. 1 shows three groups, each including the wireless device 7B, the slave control calculation device 8, the gate substrate 4, and the power converter main circuit 5. The wireless device 7A and the wireless device 7B of each group can perform wireless communications therebetween.

The slave control calculation device 8 of any one of the groups shown in FIG. 1 receives a voltage value of the capacitor of the power converter main circuit 5 of the same group and a current value detected by the current sensor 6. The voltage value and the current value may be collectively referred to as detection values. The slave control calculation device 8 of the other groups receives the voltage value mentioned above, but may not receive the current value.

An example of an operation procedure of each device will be described. In the description, it is assumed that the slave control calculation device 8 receives the current value. The control calculation device 1 calculates the output voltage command value to drive the power converter main circuit 5 of each group, and outputs the value to the wireless device 7A. The wireless device 7A converts an electric signal indicative of the output voltage command value to a wireless signal, and transmits the wireless signal to each wireless device 7B on the semiconductor switching element side.

The wireless device 7B of a destination (transmission destination) receives the transmitted wireless signal and converts it to an electric signal. Based on the electric signal, the slave control calculation device 8 of the same group as the wireless device 7B generates a gate signal to drive the semiconductor switching element of the power converter main circuit 5 of the same group, that is, the power converter to be controlled, for example, by comparison between the output voltage command value represented by the electric signal and a predetermined carrier wave. The slave control calculation device 8 transmits the gate signal to the gate substrate 4 corresponding to the power converter main circuit 5 of the same group. Based on the gate signal, the gate substrate 4 drives the semiconductor switching element of the power converter main circuit 5 of the same group, that is, the power converter to be controlled.

The slave control calculation device 8 outputs detection values, including a voltage value of the capacitor of the power converter main circuit 5 of the same group and a current value detected by the current sensor 6, to the wireless device 7B of the same group. As a result, the detection values are fed back to the control calculation device 1 by wireless communication. Based on the fed-back detection values, the control calculation device 1 calculates a new output voltage command value.

According to the first embodiment, wireless gate transmission is enabled with a small amount of information by wirelessly transmitting the output voltage command value to drive the power converter main circuit 5. As a result, the gate signal lines between the control calculation device and the main circuits provided in the conventional control device for a power converter as shown in FIG. 7 can be reduced. Therefore, gate signal transmission with high reliability is realized, while reducing costs involved in the apparatus, and dimensions of the apparatus. The same applies to transmission of various detection values by the power converter main circuit 5.

As a common matter of all embodiments, each of the wireless devices 7A and 7B may be a unidirectional communication devices or a combination thereof. Furthermore, if the power converter main circuit 5 is a current type, the output command value calculated by the control calculation device 1 is an output current command value. Also, the slave control calculation device 8 can autonomously correct an output command value based on an own terminal detection value, such as a capacitor voltage value or a current value, and then control the power converter main circuit 5 based on the output command value.

### (Second Embodiment)

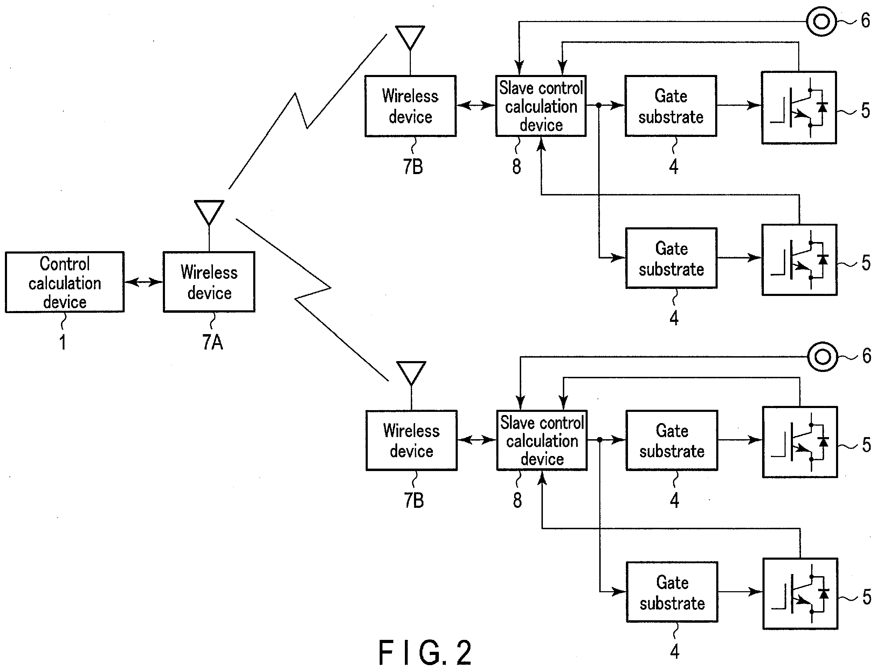

FIG. 2 is a diagram showing a configuration example of a control apparatus for a power converter according to a second embodiment. In each of the embodiments described below, the same or equivalent structural elements as those shown in FIG. 1 are described by using the same symbols as that used in FIG. 1.

In the second embodiment, it is assumed that a plurality of power converter main circuits 5 are provided, and a slave control calculation device 8 of each group transmits a gate signal to a gate substrate 4 corresponding to a power converter main circuit 5 in a one-to-one correspondence. In the example shown in FIG. 2, each group includes two power converter main circuits 5; however, each group may include three or more power converter main circuits 5.

As a result, the number of wireless devices 7B relative to the power converter main circuits 5 can be smaller than that in the first embodiment.

The control calculation device 1 calculates an output voltage command value corresponding to each group. The control calculation device 1 transmits the output voltage command value to the wireless device 7B by wireless communication via the wireless device 7A.

The slave control calculation device 8 generates a gate signal for the power converter main circuits 5 in the same group based on the output voltage command value from the wireless device 7B, and transmits the gate signal to the gate substrate 4 corresponding to each of the power converter main circuits 5. The slave control calculation device 8 transmits capacitor voltage values of the power converter main circuits 5 by wireless communication via one wireless device 7B.

According to the second embodiment, the number of wireless devices 7B is reduced as long as there is no problem in a delay of wireless communication, thereby reducing necessary wireless bands, while reducing costs.

### (Third Embodiment)

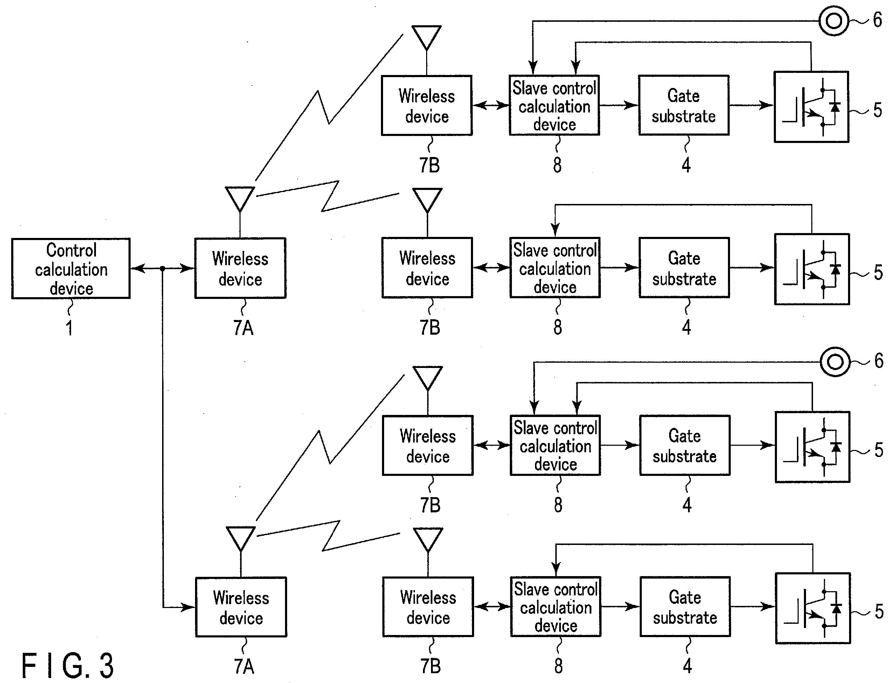

FIG. 3 is a diagram showing a configuration example of a control apparatus for a power converter according to a third embodiment.

In the third embodiment, it is assumed that a plurality of slave control calculation devices 8 and a plurality of wireless devices 7B corresponding thereto are provided, and a plurality of wireless devices 7A are provided for one control calculation device 1. The third embodiment aims at distributing loads on the wireless devices 7A on the side of the control calculation device 1 by sharing the wireless devices 7B as communication targets with the wireless devices 7A. Each of the wireless devices 7A wirelessly communicates with the wireless devices 7B on the side of the power converter main circuits 5 of predetermined groups of all wireless devices 7B on the side of the power converter main circuits 5.

As a result, the number of wireless devices 7B to be communication partners for each wireless device 7A on the side of the control calculation device 1 can be reduced as compared to the first embodiment. Therefore, each wireless device 7A enables simultaneous parallel wireless communication with a small amount of information. Accordingly, the amount of wireless communication time in the entire control apparatus can be reduced, and more reliable wireless gate transmission can be realized.

In the example shown in FIG. 3, the wireless devices 7A and 7B take charge of wireless communication with one power converter main circuit 5 as in the case of the first embodiment. However, the wireless devices 7A and 7B may take charge of wireless communication with a plurality of power converter main circuits 5 as in the case of the second embodiment. Furthermore, in the example shown in FIG. 3, each group includes two wireless devices 7B; however, each group may include one wireless device 7B.

### (Fourth Embodiment)

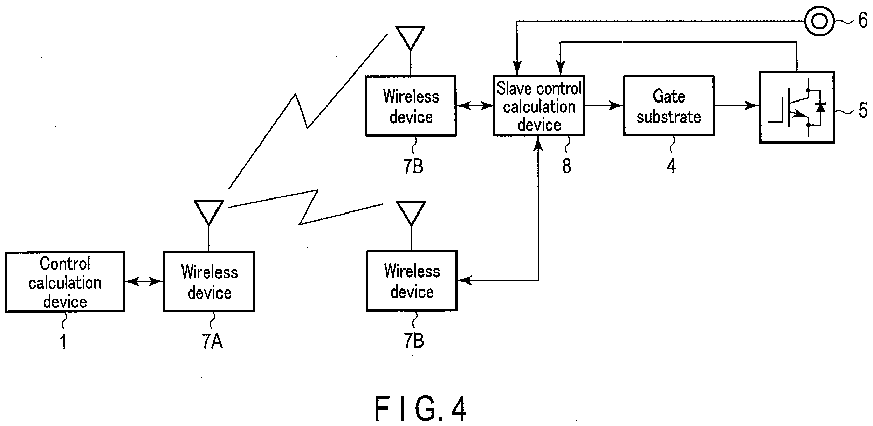

FIG. 4 is a diagram showing a configuration example of a control apparatus for a power converter according to a fourth embodiment.

As shown in FIG. 4, the fourth embodiment includes a plurality of wireless devices 7B. The wireless devices 7B perform identical wireless communication with a wireless device 7A on the side of a control calculation device 1.

A slave control calculation device 8 compares signals received by the wireless devices 7B, and determines whether there is a difference or lack of information, etc., thereby determining whether there is a communication error between the wireless device 7A and the wireless devices 7B.

If there is a communication error, the slave control calculation device 8 may stop operation of a semiconductor switching element by a gate block of the semiconductor switching element. Alternatively, the slave control calculation device 8 may transmit a signal indicative of occurrence of an error to the side of the control calculation device 1 by wireless communication, and may transmit an operation stop command transmitted from the side of the control calculation device 1 to the semiconductor switching element on the side of the slave control calculation device 8.

Accordingly, since the fourth embodiment can reliably determine whether there is a communication error, it can realize wireless gate transmission with high reliability.

Furthermore, a plurality of wireless devices 7A may be provided on the side of the control calculation device 1 and the wireless devices 7A may perform identical wireless communication with the wireless devices 7B, so that the control calculation device 1 can compare signals received by the wireless devices 7A, thereby determining whether there is a communication error.

### (Fifth Embodiment)

The fifth embodiment is applicable to any of the embodiments described above.

In the fifth embodiment, a slave control calculation device 8 compares a detection value, for example, a voltage value or a current value of a power converter main circuit 5, with a predetermined threshold (a threshold for a voltage value or a threshold for a current value) stored in a storage device in the slave control calculation device 8. By the comparison, the slave control calculation device 8 determines whether the voltage value is greater than the threshold, that is, whether the voltage is an overvoltage, or whether the current value is greater than the threshold, that is, whether the current is an overcurrent. By the determination, the slave control calculation device 8 determines whether or not the detection value is an abnormal value. The abnormal value indicates that the voltage value or the current value of the power converter main circuit 5 is abnormal.

When the slave control calculation device 8 determines that the detection value is an abnormal value, it outputs a gate block signal for a semiconductor switching element to a gate substrate 4, and stops operations.

Furthermore, the slave control calculation device 8 feeds back an abnormality occurrence signal, indicative of an abnormality of a detection value, to the control calculation device 1 by wireless communication with the wireless devices 7B and the wireless device 7A.

When the abnormality occurrence signal is input from the wireless device 7A, the control calculation device 1 transmits a gate block signal to all other slave control calculation devices 8 by wireless communication. Upon receipt of the gate block signal, each slave control calculation device 8 performs gate block processing for the semiconductor switching element.

As described above, according to the fifth embodiment, when the detection value of the power converter main circuit 5 is abnormal, immediate processing can be performed. Therefore, wireless gate transmission with high reliability can be realized.

### (Sixth Embodiment)

The sixth embodiment is applicable to any of the first to fifth embodiments. In the sixth embodiment, a slave control calculation device 8 determines whether or not there is a communication error for a predetermined period of time or longer, or whether or not the communication is stopped for a predetermined period of time or longer in communication between a wireless device 7B and a wireless device 7A, etc. Based on the determination, the slave control calculation device 8 determines whether correct communication between the wireless device 7B and the wireless device 7A has or has not been established for the predetermined period of time or longer.

When it is determined that the correct communication has not been established for the predetermined period of time or longer, the slave control calculation device 8 performs the gate block processing of the fifth embodiment described above.

Accordingly, the sixth embodiment can avoid an abnormal operation of the power converters, which may result from an abnormality in wireless communication. Therefore, wireless gate transmission with high reliability can be realized.

### (Seventh Embodiment)

The seventh embodiment is applicable to any of the first to fifth embodiments. In the seventh embodiment, a slave control calculation device 8 stores, in a storage device in the slave control calculation device 8, a previous value of the output voltage command value, that is, an output voltage command value calculated at the preceding calculation timing prior to the calculation timing of the latest output voltage command value. The previous value is stored each time an output voltage command value is input to the slave control calculation device 8 from the control calculation device 1 by wireless communication.

When it is determined that correct communication between wireless devices has not been established, the slave control calculation device 8 reads the previous value from the storage device, and continues to convert the output voltage command value represented by the previous value to a gate signal and to output the gate signal, until a predetermined period of time elapses after the determination.

Furthermore, in the seventh embodiment, the control calculation device 1 stores, in a storage device in the control calculation device 1, previous values of detection values of the capacitor voltage or the current. When it is determined that correct communication between wireless devices has not been established, the control calculation device 1 reads the previous value from the storage device, and continues calculation of the output voltage command value using the previous value, until a predetermined period of time elapses after the determination.

When the predetermined period of time has elapsed, the slave control calculation device 8 performs the gate block processing of the fifth embodiment described above. The control calculation device 1 transmits the gate block signal to the slave control calculation device 8 by wireless communication.

As a result, according to the seventh embodiment, in temporary abnormal communication conditions, the power converter is not immediately stopped. Thus, since a temporary minor abnormality of wireless communication cannot result in a significant abnormal operation, wireless gate transmission with high reliability is realized.

### (Eighth Embodiment)

The eighth embodiment is applicable to any of the first to fifth embodiments described above. In the eighth embodiment, a slave control calculation device 8 calculates a slope of a change of the output voltage command value, based on a difference between the latest value of the output voltage command value, that is, the output voltage command value calculated at the latest timing and the previous value described in the description of the seventh embodiment.

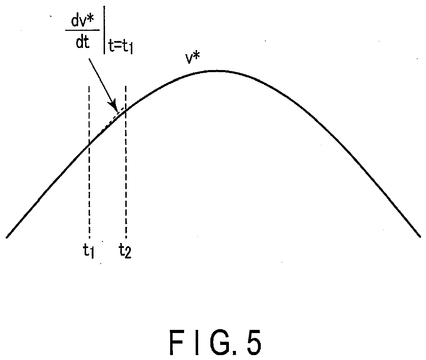

FIG. 5 is a diagram for explaining an example of inertia control performed during a communication error time by the slave control calculation device 8 of the eighth embodiment. In FIG. 5, v* represents an output voltage command value transmitted by a control calculation device 1.

At time t₁ shown in FIG. 5, when it is determined that correct communication between a wireless device 7A and a wireless device 7B is not established, the slave control calculation device 8 estimates a change in the output voltage command value by time t₂ shown in FIG. 5 based on the calculated slope until time t₂ after the determination. Based on the estimation result, the slave control calculation device 8 changes the actual output voltage command value until time t₂, and converts the output voltage command value to a gate signal.

After time t₂ shown in FIG. 5, the slave control calculation device 8 performs the gate block processing of the fifth embodiment described above.

Thus, in the eighth embodiment as well as the seventh embodiment, a temporary minor abnormality of wireless communication cannot result in a significant abnormal operation. Therefore, wireless gate transmission with high reliability can be realized.

The eighth embodiment is also applicable to a control calculation device 1. In this case, the control calculation device 1 calculates a slope of a change of a detection value, based on a difference between the latest detection value from the slave control calculation device 8 and the previous value described in the description of the seventh embodiment.

At a first time, when it is determined that correct communication between the wireless device 7A and the wireless device 7B is not established, the control calculation device 1 estimates a change in the detection value by a second time based on the calculated slope until the second time after the determination. Based on the estimated result, the control calculation device 1 calculates an actual output voltage command value by the second time.

After the second time, the control calculation device 1 transmits a gate block signal to the slave control calculation device 8 by wireless communication.

### (Ninth Embodiment)

The ninth embodiment is applicable to any of the first to fifth embodiments. In the ninth embodiment, a slave control calculation device 8 stores, in a storage device of the slave control calculation device 8, an output voltage command value of one cycle of a latest fundamental wave and an output voltage command value of one cycle of a fundamental wave of the previous cycle.

Based on the stored value, the slave control calculation device 8 calculates an average value of a value at a time point of the latest cycle and a value at a time point of the previous cycle, thereby calculating an average output voltage command value of one cycle of the fundamental wave.

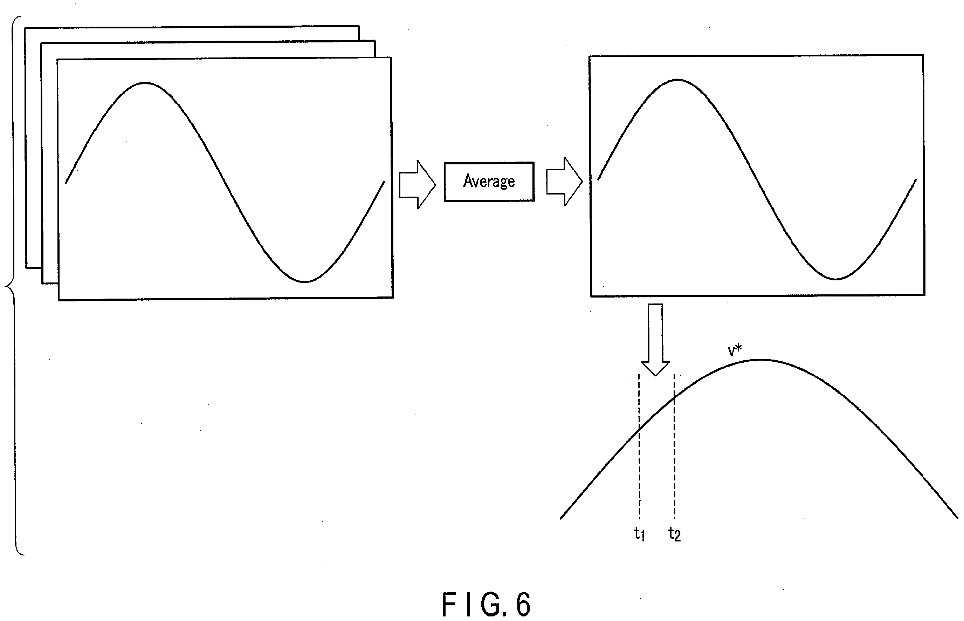

FIG. 6 is a diagram for explaining an example of inertia control based on an average value in communication error time according to the ninth embodiment. In FIG. 6, v* represents an output voltage command value transmitted by a control calculation device 1.

At time t₁ shown in FIG. 6, when it is determined that correct communication between a wireless device 7A and a wireless device 7B is not established, the slave control calculation device 8 estimates a change in the output voltage command value by time t₂ shown in FIG. 6 based on the calculated average output command voltage value until time t₂ after the determination. Based on the estimation result, the slave control calculation device 8 changes the actual output voltage command value until time t₂, and converts the output voltage command value to a gate signal.

After time t₂ shown in FIG. 6, the slave control calculation device 8 performs the gate block processing of the fifth embodiment described above.

Thus, in the ninth embodiment as well as the seventh and eighth embodiments, a temporary minor abnormality of wireless communication cannot result in a significant abnormal operation. Therefore, wireless gate transmission with high reliability can be realized.

The ninth embodiment is also applicable to a control calculation device 1. In this case, the control calculation device 1 stores, in a storage device in the control calculation device 1, a detection value of one cycle of the latest fundamental wave from the slave control calculation device 8 and a detection value of one cycle of the fundamental wave of the previous cycle, that is, a previous value.

Based on the stored value, the control calculation device 1 calculates an average value of a value at a time point of the latest cycle and a value at a time point of the previous cycle, thereby calculating an average detection value.

At a first time, when it is determined that correct communication between a wireless device 7A and a wireless device 7B is not established, the control calculation device 1 estimates a change in the detection value by a second time based on the calculated average detection value until the second time after the determination. Based on the estimated result, the control calculation device 1 calculates an actual output voltage command value by the second time.

After the second time, the control calculation device 1 transmits a gate block signal to the slave control calculation device 8 by wireless communication.

### (Tenth Embodiment)

The tenth embodiment is applicable to any of the embodiments described above.

In the tenth embodiment, a slave control calculation device 8 transmits a detection value of a capacitor voltage to a wireless device 7B only once in a plurality of wireless communication cycles. The detection value is transmitted from the wireless device 7B to a side of a control calculation device 1 via a wireless device 7A. If a capacitor time constant is sufficiently large in the design of a power converter, the capacitor voltage changes sufficiently slowly relative to a control cycle, and does not change rapidly. Therefore, the communication frequency of the capacitor voltage can be decreased.

As a result, the time of wireless communication between the side of the slave control calculation device 8 and the side of the control calculation device 1 can be reduced. Accordingly, wireless gate transmission with higher reliability can be realized.

### (Eleventh Embodiment)

The eleventh embodiment is applicable to any of the embodiments described above.

A control calculation device 1 stores a previous value of an output voltage command value in a storage device of the control calculation device 1. The control calculation device 1 calculates, instead of an output voltage command value itself, a difference between a previous value of the output voltage command value and a newly calculated output voltage command value, and transmits the difference to a slave control calculation device 8 by wireless communication.

The slave control calculation device 8 stores, in a storage device of the slave control calculation device 8, previous values of detection values of a capacitor voltage value and a current value of a main circuit. The slave control calculation device 8 calculates a difference between the newly detected capacitor voltage value or current value and the previous value, and transmits the difference to the control calculation device 1 by wireless communication.

As described above, according to the eleventh embodiment, information on transmission between the control calculation device 1 and the slave control calculation device 8 is transmitted as a difference between the previous value and the newly calculated or detected value, thereby reducing the amount of communication information. Accordingly, the amount of wireless communication time can be reduced, and more reliable wireless gate transmission can be realized.

The embodiments described above are represented as examples, and do not restrict a scope of the invention. Indeed, the novel embodiments described herein may be embodied in a variety of other forms; furthermore, various omissions, substitutions and changes in the form of the embodiments described herein may be made without departing from the spirit of the invention. The embodiments and modifications are included in the scope and gist of the invention, and also included in the invention recited in the claims and the scope of equivalents of the invention.

### REFERENCE SIGNS LIST

1 ... control calculation device, 2 ... parallel/serial converter, 3 ... electrical/optical converter (optical/electrical converter), 4 ... gate substrate, 5 ... Power converter main circuit, 6 ... current sensor, 7A and 7B ... wireless device, 8 ... Slave control calculation device

## Claims

1. A control apparatus for a power converter, the apparatus comprising:
a first control calculation device (1) that calculates an output command value of one or more main circuits (5) including a semiconductor switching element; and
one or more second control calculation devices (8) that convert the output command value to a gate signal of the semiconductor switching element, wherein:
the output command value is transmitted from the first control calculation device (1) to the second control calculation devices (8) by wireless communication; and
the second control calculation devices (8) transmit the gate signal converted from the transmitted output command value to a gate substrate (4) that drives the semiconductor switching element based on the gate signal.

2. The control apparatus for the power converter of claim 1, wherein:
the one or more main circuits (5) are a plurality of main circuits; and
the second control calculation devices (8) transmit the gate signal to the gate substrate (4) corresponding to a power converter in a one-to-one correspondence.

3. The control apparatus for the power converter of claim 1 or 2, the apparatus further comprising a plurality of wireless communication devices (7A) on a side of the first control calculation device (1), wherein:
the one or more second control calculation devices (8) are a plurality of devices; and
the wireless communication devices (7A) on the side of the first control calculation device (1) share the second control calculation devices (8) as communication targets.

4. The control apparatus for the power converter of claim 1, wherein:
a plurality of wireless communication devices are provided for at least one of the first control calculation device and the second control calculation devices (8); and
the wireless communication devices provided for one of the first control calculation device and the second control calculation devices (8) perform identical wireless communication with another of the first control calculation device and the second control calculation devices (8), and
the control apparatus determines a communication error by comparing signals received by the identical wireless communication.

5. The control apparatus for the power converter of claim 1, wherein:
the main circuits (5) each include
(1) a DC voltage source and voltage value detecting means therefor, or
(2) a detecting means as a current detecting means for detecting a current flowing through the main circuits (5); and
the second control calculation devices (8),
determine whether there is an abnormality in a quantity of electricity of the main circuits (5) based on a detection value detected by the detecting means,
gate-block the semiconductor switching element, when it is determined that there is abnormality, and
transmit an abnormality signal indicative of the abnormality to the first control calculation device (1) by wireless communication.

6. The control apparatus for the power converter of claim 1, wherein the second control calculation devices (8) gate-block the semiconductor switching element, when wireless communication with the first control calculation device (1) is not established for a predetermined period of time or longer.

7. The control apparatus for the power converter of claim 1, wherein the second control calculation devices (8)
store, in a storage device, a previous value of the output command value transmitted by wireless communication from the first control calculation device (1), and
convert the stored previous value to the gate signal, when wireless communication with the first control calculation device (1) is not established.

8. The control apparatus for the power converter of claim 1, wherein the second control calculation devices (8)
store, in a storage device, a previous value of the output command value transmitted by wireless communication from the first control calculation device (1),
calculate a slope of a change of the output command value, based on a difference between a latest value of the output command value and the previous value, and
estimate a subsequent value of the output command value based on the calculated slope of the change, when predetermined wireless communication with the first control calculation device (1) is not established.

9. The control apparatus for the power converter of claim 1, wherein the second control calculation devices (8)
calculate an average value of values at time points of cycles of fundamental waves of output command values of a plurality of cycles transmitted from the control calculation device (1) by wireless communication, and
estimate a subsequent value of the output command value based on the calculated average value, when predetermined wireless communication with the first control calculation device (1) is not established.

10. The control apparatus for the power converter of claim 1, wherein the first and second control calculation devices (8)
store a previous value of information transmitted to a control calculation device of a destination of transmission by wireless communication, and
transmit a difference between information to be newly transmitted by wireless communication and the previous value to the destination of transmission.
